·Europäisches Patentamt

European Patent Office

Office européen des brevets

(19)

(11) Publication number: 0 364 409
A1

## (12) EUROPEAN PATENT APPLICATION

(21) Application number: 89830379.7

(22) Date of filing: 06.09.89

(51) Int. Cl.5: H01L 21/60 , H01L 21/90

(30) Priority: 14.09.88 IT 8366088

(43) Date of publication of application:
18.04.90 Bulletin 90/16

(84) Designated Contracting States:
DE FR GB NL SE

(71) Applicant: SGS-THOMSON
MICROELECTRONICS s.r.l.
Via C. Olivetti, 2
I-20041 Agrate Brianza Milano(IT)

(72) Inventor: Gualandris, Fabio
Via Degli Albani, 17
I-241000 Bergamo(IT)
Inventor: Marmiroli, Andrea
Via Savio, 32
I-24022 Alzano Lombardo(IT)

(74) Representative: Pellegri, Alberto et al
c/o Società Italiana Brevetti S.p.A. Via
Cavour, 9
I-21100 Varese(IT)

(54) Formation of submicron contacts by means of conducting pillars formed on the wafer and planarized.

(57) Submicron contacts and interconnections are made by forming conducting pillars over the contact areas by defining said pillars from a conducting matrix layer or multilayer previously deposited over the wafer's surface before depositing an insulating layer of dielectric. The process comprises depositing an etch stop and metallurgical barrier film, e.g. of titanium, on the surface of the wafer, depositing a layer of doped polycrystalline silicon of a sufficient thickness over the titanium, defining by a masking step plugs of photoresist over the contact areas, etching the conducting matrix layer and removing the residual titanium film from unmasked areas thus leaving "conducting pillars" on contact areas, insulating the pillars with a TEOS layer, depositing a planarization SOG layer and etching back until exposing the peaks of the preformed conducting pillars and depositing the second level metal over the planarized wafer surface in contact with the surfacing peaks of the preformed pillars.

FIG.1

FIG.8

## FORMATION OF SUBMICRON CONTACTS BY MEANS OF CONDUCTING PILLARS FORMED ON THE WAFER AND PLANARIZED

### BACKGROUND OF THE INVENTION

One of the challenging problems in submicrometer (VLSI and ULSI) monolithic integration technologies is the formation of contacts or multilevel interconnactions. Common techniques for forming submicron contacts impose a refiniment of several fabrication steps, such as: the lithographic definition of features having both orthogonal dimensions in a submicrometric range (i.e. coping with very stringent diffraction limits, a reliable deposition of metal within submicron holes and over substantially vertical steps and techniques associated thereto. Lately a reverse image photolithographic definition method has been developed which, by employing special photoresist materials wherein the latent image may be inverted through a peculiar treatment before development, permits the use of positive photoresists having a much greater definition potential than that of customary negative photoresists. By using short wavelenght radiation and high resolution optics, contacts of 0.7-0.8 micrometer may be defined. However a good metal coverage over the necessarily steep walls of submicron holes remains difficult to ensure.

Lately a process has been proposed for solving the problem of filling the holes (the so-called "plug" process), but this new process does not relieve the problems connected with the photolithograpic definition step. This "plug" process contemplates the definition of the contact areas by masking and etching an insulating dielectric layer and the filling of the contact "holes" with tungsten or heavily doped polycrystalline silicon or tungsten silicide deposited by chemical vapor deposition (CVD). By means of a successive "etch back" treatment, the deposited film of conducting material is removed leaving the contact holes in the dielectric layer partially filled (plugged) with conducting material. A metal layer is subsequently deposited.

This solution though improving the step coverage still requires definition and formation of submicron holes through a dielectric layer for making the contacts.

Another approach to the solution of these problems specifically directed to the formation of contacts and multi-level interconnactions of small dimensions having reduced step coverage problems, is disclosed in the article entitle "Reverse Pillar and Maskless contact - Two novel Recessed Metal Schemes And Their Comparisons To Conventional VLSI Metallization Schemes" by J.L. Yeh, G.W. Hills, and W.T. Cochran, June 13-14, 1988, V-MIC Conf. - IEEE. The method disclosed is essentially based on the formation of trenches in the dielectric material to be filled with a metal through a single metal deposition step through which also contact holes an the bottom of the trenches are simultaneously filled by the metal which is then etched back to leave a metal residue in the trenches (interconnections) and in the contact holes (plugs).

### OBJECTIVES AND SUMMARY OF THE INVENTION

A main objective of the present invention is to provide a method for forming contacts or interconnecting paths between conducting layers of different level in a wafer been fabricated, capable of sensibly reducing photolithographic definition problems for submicron areas as well as step coverage problems and which may be easily practiced with common apparatuses and materials.

Basically the method of the invention relies upon the formation of conducting pillars in the respective areas of contacts to be formed before forming the insulating dielectric layer on the semiconducting or on the conducting layer to be contacted. The dielectric layer is formed around the preformed conducting pillars using a planarization procedure. An upper level conducting layer may then be deposited over a planarized surface and in contact with the peaks of the pillars surfacing from the planarizing dielectric layer.

In respect to the known technique of defining and forming submicron holes through an insulating layer of dielectric material followed by the filling of the holes with a conducting material, the method of the present invention has the advantages of using a definition of submicron "islands" instead of holes which can be carried out decisively with less lithographic difficulties, of completely eliminating step coverage problems and of requiring less fabrication steps in respect to the known "plug" techniques using tungsten or heavily doped polycrystalline silicon or tungsten silicide deposited by chemical vapor deposition for filling (plugging) submicron holes formed through the thickness of the insulating layer of dielectric material.

### BRIEF DESCRIPTION OF THE DRAWINGS

The invention will now be described by illustrating the basic process steps with reference to the annexed drawing and in accordance with a preferred embodiment.

**Figures from 1** to **8** depicts the basic steps of the pro cess of the invention for forming contacts or interconnections between different semiconducting or conducting levels.

## DESCRIPTION OF THE PREFERRED EMBODIMENT

The figures depict a partial cross section view of a wafer being fabricated wherein on a monocrystalline semiconducting silicon substrate 1 an active area is defined by a field oxide 2 grown on the silicon surface.

After having defined a first or gate metal level 3, commonly of heavily doped polycrystalline silicon having a relatively low resistivity and differently from known methods which contemplate the deposition of a first dielectric layer through which subsequently opening the contacts, in accordance with the process of the present invention any gate oxide layer present on the source and drain areas is etched until exposing the monocrystalline silicon 1 within the active areas and simultaneously providing, by the same etching treatment, a "cleaning" of the surface of the previously defined polycrystalline gate silicon runner 3. Preferably the etching is carried out in a RIE type plasma, using a plasma of $C_2F_6/O_2$; i.e. a plasma capable of generating a negligeable amount of polymerization products and hydrogen in order to avoid contamination of the contact areas of the silicon with polymeric residues and/or implanted hydrogen atoms. Commonly the etching may be protracted until peeling off for a maximum depth of about 100 Angstroms both the monocrystalline silicon 1 within the active areas and the surface of the polycrystalline silicon gate runner 3.

For further ensuring that the surface of the monocrystalline silicon be free of contaminants an annealing treatment under nitrogen at about 600°C for about three hours may be performed in order to eliminate possible traces of fluorine and/or carbon which could have remained absorbed at the end of the etching process of the gate oxide layer in the source and drain areas.

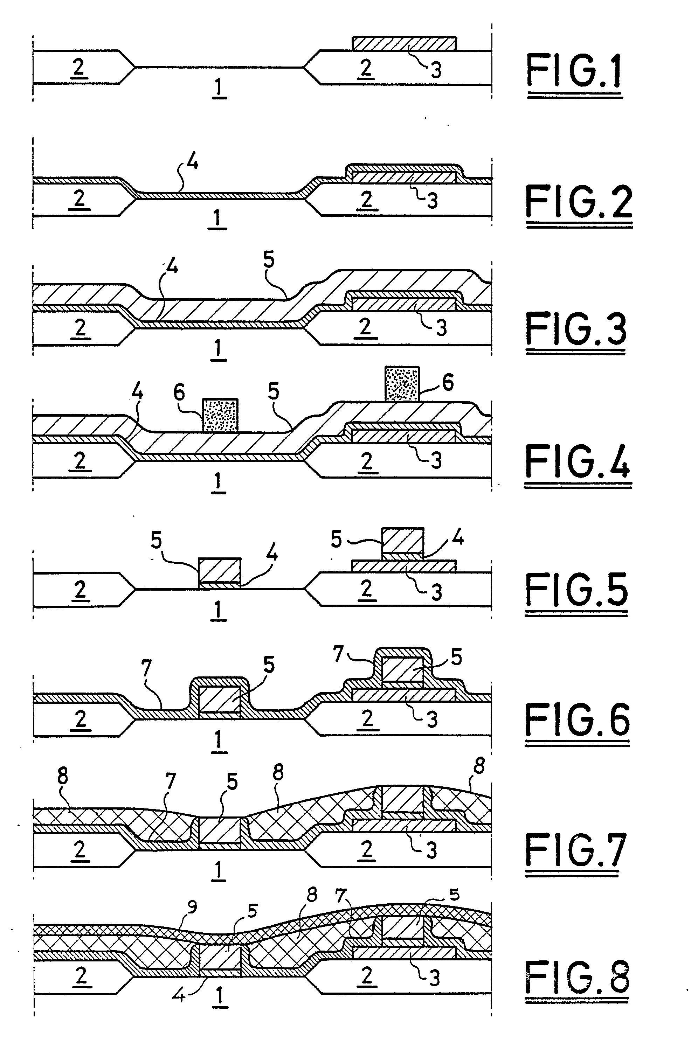

On the wafer surface so prepared, as shown in Fig.1, a layer of titanium 4, with a thickness preferably comprised between 800-900 Angstroms is deposited by a sputter deposition process (or by any equivalent process). The titanium film 4 has the double function of an etch stop layer and of a metallurgical barrier layer, as it will be discussed later (Fig. 2).

On the titanium film 4 a layer of polycrystalline silicon 5 with a thickness comprised preferably between 4000 and 6000 Angstroms is deposited by chemical vapor deposition conducted at about 580°C. The polycrystalline silicon layer 5 is heavily doped in order to lower its bulk resistivity. During this step the underlaying titanium film 4 prevents diffusion of the dopant species in the active areas of the monocrystalline silicon substrate 1. Instead of doped polycrystalline silicon any other suitable conducting material may also be used, e.g. tungsten or tungsten silicide, deposited by chemical vapor deposition (Fig. 3). The superimposed conducting layers 4 and 5 constitute a multilayer conducting matrix for the contacts to be formed.

By means of a normal masking step using standard masks and the image reversal technique, plugs 6 of photoresist having a cross section substantially identical to the desired cross section of the contacts or interconnections (substantially of submicron dimensions) are projectively defined over the areas of the contacts to be formed (Fig. 4).

At this point the conducting layer 5 is anisotropically etched in a RIE type plasma until exposing the underlying titanium film (etch stop), which is particularly effetive in generating a distinct signal when the etching reaches the titanium. The residual titanium layer exposed at the bottom of the etch hole through the conducting layer 5 is then removed so as the residual masking photoresist. At the end of the etching and of the titanium and photoresist removal, the cross section becomes as shown in Fig. 5.

On the contact areas (on the surface of the monocrystalline silicon substrate 1 within the active areas, as well as on the surface of the runners of the first or gate metal level) conductive pillars having a submicron cross section and constituted by a titanium barrier layer portion 4 and by a riser portion of a different conducting material 5, such as doped polycrystalline silicon, are so formed.

A first insulating layer of dielectric material 7 having a thickness of about 2000 - 4000 Angstroms , based on a silicon oxide conformally deposited from tetraethylorthosilicate (TEOS) by a low pressure chemical vapor deposition process (LPCVD), is formed, as depicted in Fig. 6.

Over this first dielectric layer 7 of TEOS, a second planarization dielectric layer 8 is deposited, e.g. a Spun On Glass (SOG) formed by using a siloxane diluted in alcohol and applied in a liquid state by a rotating plate dispenser similar to those used for dispensing photoresist material and successively heat treated for converting it into a dielectric glass having a desired morphologically smoothed surface. The planarization SOG is distributed over the surface of the wafer in a quantity sufficient to substantially submerge completely the existing superficial morphological features of the wafer, in particular the conducting pillars 5 already covered by the first insulating TEOS layer 7. By an etch-back process the peaks of the con ducting pillars 5 are exposed, as depicted in Fig. 7.

The second level metal layer 9 may then be deposited over the planarized surface of the wafer and in contact with the surfacing peaks of the distinct preformed conducting pillars 5, as depicted in Fig. 8.

A customary masking step for geometrically defining the runners or conducting paths of the second metal level will ensue and the fabrication process may then continue in accordance with a standard sequence of steps.

## Claims

1. A method for forming contacts with at least a semiconducting or conducting layer of a wafer which comprises:

a) exposing and cleaning the surface of a wafer's layer to be contacted;

b) depositing an etch stop, first conducting layer of a diffusion barrier material over the surface of the wafer;

c) depositing over said first conducting layer at least a second layer of a conducting material with a thickness sufficient to form a multilayer conducting matrix of said contacts to be formed;

d) depositing a layer of photoresist material and photolithographically defining plugs of photoresist having a cross section substantially equivalent to the desired cross section of said contacts projectively over areas of said contacts to be formed;

e) anisotropically etching said second conducting layer in areas unmasked by said photoresist plugs until exposing said etch stop first conducting layer;

f) removing the residual photoresist of said plugs and said etch stop first conducting layer in exposed areas, thus defining conducting pillars from said matrix extending from the surface of said layer to be contacted for a height corresponding to the sum of the thickness of said first conducting layer of barrier material and of said second layer of conducting material;

g) conformally depositing a first layer of a dielectric material over the surface of the wafer containing said conducting pillars;

h) depositing a planarization second layer of dielectric material having a thickness sufficient to submerge completely said conducting pillars;

i) etching back said planarization second layer of dielectric material until exposing the peaks of said conducting pillars; and

l) depositing and geometrically defining a metal layer for electrically connecting the contacts formed by said conducting pillars.

2. The method according to claim 1, wherein said first conducting layer is a layer of titanium, said second layer of a conducting material is a layer of heavily doped polycrystalline silicon and said first dielectric layer is a layer of silicon oxide formed by low pressure chemical vapor deposition from tetraethylorthosilicate.

FIG.1

FIG.2

FIG.3

FIG.4

FIG.5

FIG.6

FIG.7

FIG.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| Y | EXTENDED ABSTRACTS, vol. 87-1, no. 1, Spring 1987, page 274, abstract no. 191, Philadelphia, PA, US; E.D. CASTEL et al.: "Multilevel metallization with pillar interconnects and planarization" * Whole article * | 1 | H 01 L 21/60<br>H 01 L 21/90 |
| Y | EP-A-0 129 389 (PLESSEY OVERSEAS LTD) * Page 7, lines 1-12; page 8, line 22 - page 9, line 3 * | 1 | |
| A | | 2 | |
| A | SOLID STATE TECHNOLOGY, vol. 27, no. 12, December 1984, pages 93-100, Port Washington, New York, US; A.N. SAXENA et al.: "VLSI multilevel metallization" * Tables 3-5 * | 2 | |
| A | S.J. MOSS et al.: "The chemistry of the semiconductor industry", 1987, pages 117-118, Blackie and Son Ltd, Glasgow, GB * Page 118, paragraph 2 * | 2 | TECHNICAL FIELDS SEARCHED (Int. Cl.5)<br><br>H 01 L |
| A | 1986 PROCEEDINGS THIRD INTERNATIONAL IEEE VLSI MULTILEVEL INTERCONNECTION CONFERENCE, Santa Clara, CA, 9th-10th June 1986, pages 506-515, IEEE, New York, US; L.B. VINES et al.: "Interlevel dielectric planarization with spin-on glass films" * Page 509, paragraph 3 * | 1 | |

The present search report has been drawn up for all claims

| Place of search | Date of completion of the search | Examiner |
|---|---|---|
| THE HAGUE | 22-12-1989 | PHEASANT N.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)